Europäisches Patentamt

European Patent Office

Office européen des brevets

(11) Publication number: **0 384 524**
**A2**

# (12) EUROPEAN PATENT APPLICATION

(21) Application number: **90200369.8**

(22) Date of filing: **19.02.90**

(51) Int. Cl.5: **H01L 21/00**

(30) Priority: **24.02.89 US 315068**

(43) Date of publication of application:
**29.08.90 Bulletin 90/35**

(84) Designated Contracting States:
**CH DE FR GB LI NL**

(71) Applicant: **North American Philips Corporation**
**100 East 42nd Street 9th Floor**
**New York, N.Y. 10017(US)**

(72) Inventor: **Toro-Lira, Guillermo Luis**
**c/o INT. OCTROOIBUREAU B.V. Prof. Holstlaan 6**
**NL-5656 AA Eindhoven(NL)**
Inventor: **Abel, Alan Christopher**
**c/o INT. OCTROOIBUREAU B.V. Prof. Holstlaan 6**
**NL-5656 AA Eindhoven(NL)**
Inventor: **Achilles, Alan Harvey**
**c/o INT. OCTROOIBUREAU B.V. Prof. Holstlaan 6**
**NL-5656 AA Eindhoven(NL)**

(74) Representative: **Zwaan, Andries Willem et al**
**INTERNATIONAAL OCTROOIBUREAU B.V.**
**Prof. Holstlaan 6**
**NL-5656 AA Eindhoven(NL)**

(54) **Wafer transfer system.**

(57) The invention describes a wafer transfer system for high speed loading of wafers, such as semiconductor wafers, into vacuum chamber for various applications such as inspection or processing using, for example, a SEM. This system provides low contamination from atmospheric conditions both on loading and unloading the wafers.

FIG. I

EP 0 384 524 A2

## Wafer transfer system.

The invention relates to a wafer transfer system for transferring a wafer from a space at a predetermined pressure into a vacuum chamber through an opening in the vacuum chamber.

A wafer transfer system of the above mentioned kind is known from the US patent No. 4,604,020. Wafer transfer systems are a critical part for a number of different processes particularly metrology instruments, such as in the inspection or processing of flat samples, such as magnetic discs, and further in any such applications requiring a vacuum. In this respect, electron beam lithography, plasma etchers, scanning electron microscopy (SEM), and laser and conventional light optics are among many applications requiring contamination-free wafer handling. In-vacuum wafer handling is one of the most important factors affecting inspection speeds of the SEM. In addition to the vacuum requirement, the relatively low signal-to-noise ratio of images in the produced SEM inspection are the main reasons why light-optics microscopes are generally faster and easier to operate. Further, the vacuum environment can create negative secondary effects to the device wafers, and can also increase the potential of particle and other types of contamination.

Electron beam systems require the wafer to be under vacuum. Semiconductor wafers are sensitive to minute quantities of contamination and must be afforded "clean" pressure transition and transport so as not to compromise their quality. This must be accomplished repeatedly and reliably at sufficient speeds to enable the measuring instrument to accommodate production line quantities of hundreds of wafers per day. The known wafer transfer system, more particular, an integrated circuit wafer handler, uses an additional vacuum chamber that is outside the vacuum chamber, from which with the aid of motor driven magnetic structures a wafer can be transferred into the vacuum chamber.

It is an object of the invention to provide a wafer transfer system that can be utilised in vacuum applications to substantially reduce inherently slow wafer exchange times of the SEM, for example. It is also an object of the invention to minimize the potential of particle contamination onto or into the wafers.

A wafer transfer system according to the invention is characterized in that the transfer system comprises door means for removably covering the opening, elevator means located at least partly inside the vacuum chamber comprising a stage for moving wafers from the opening into the vacuum chamber, and sealing means for forming a vacuum seal between sides of the stage and walls bounding the opening.

By minimizing internal moving parts in the vacuum chamber upon loading, contamination of the wafer is reduced.

The sealing means between the stage and the walls of the opening is for example a highly reliable inflatable elastomer activated by gas pressure. This sealing means produces low contamination levels, since it requires no mechanical moving parts in the lock chamber and is positioned below the wafer. Seal integrity is not influenced by the force of atmospheric pressure that acts on the elevator. The bulk of this force is transferred to the vacuum chamber through an elevator drive linkage. An embodiment of a wafer transfer system according to the invention is characterized in that a lock chamber is enclosed by the door means and the stage, opposite sides of the lock chamber having approximately equal shape and surface area as the wafers.

The lock chamber is of minimum volume, that is, similar to the volume of one or a few wafers. By this, wafers can be inserted into the vacuum chamber with minimum loss of vacuum. The amount of gas introduced upon loading the lock chamber is minimized and a fast pressure transistion is possible. The small volume of the lock chamber also allows the lock chamber to be built into the door, eliminating the need for a separate lock chamber external to the system.

A further embodiment of a wafer transfer system according to the invention is characterized in that transfer means are located at least partly within the vacuum chamber, for positioning the wafers within the vacuum chamber.

High throughput for single wafer inspection is achieved due to the minimum vacuum lock chamber size associated with the gas load. High throughput for queueing wafer inspection due to the use of the transfer means, preferably an internal rotary arm, achieves advantages in swapping incoming an outgoing wafers.

A further embodiment of a wafer transfer system according to the invention is characterized in that the door means is movable in the same direction as the elevator means, part of the circumference of the door means being enclosed by a sealing structure, that is connected to an outer part of the vacuum chamber.

The door and sealing structure provide optimum controllable gas "purging" conditions that minimize the potential of introducing environmental contaminants, such as humidity, particles, and other contaminations into the load chamber during wafer introduction into the vacuum chamber. When the outer door is unsealed or opened, airborn contamination and humidity are restricted form lock chamber entry by the minimal opening of the door, a positive dry gas purging from the lock chamber, and the sealing structure that further restricts the opening to the lock chamber.

Another embodiment of a wafer transfer system according to the invention is characterized in that a further seal is provided between the door means and an outer part of the vacuum chamber, the sealing means and the further seal being of circular shape.

The further seal of the door is for example a solid circular elastomer O-ring. The further seal is activated in a manner that applies or removes sealing compression with minimal sliding force. This minimizes contaminant particle generation in the lock. The small distance (about 1 cm) that the seal moves to permit wafer transfer provides for high speed operation. A highly reliable, electro-pneumatic driving mechanism for this seal is located external to the lock chamber to eliminate contamination from its moving parts. Because the vacuum seals are circular, they present minimal mechanical sliding friction during actuation. This enables long-term reliability of several orders of magnitude higher than typical rectangular gate valves. There are no mechanical moving parts inside the load lock chamber. Therefore, no static or kinetic friction occurs that may cause generation of particles to contaminate the wafers. The prior art techniques of "slow venting" and "slow rough" procedures to minimize the effect of particles contaminations into the wafers due to gas turbulence effects are then eliminated.

The presently claimed invention sets forth a wafer transfer system that can be utiziled in vacuum applications to substantially reduce inherently slow wafer exchange times of the SEM, for example. It also minimizes the potential of particle contamination onto or into the wafers.

The invention provides reliable, clean, high speed transfer of wafers, such as semiconductor wafers including integrated circuits, from a place of normal atmospheric pressure to a place of vacuum pressure and from the vacuum back to atmosphere. It is also applicable to operations involving the clean, rapid transport of an object from one zone of ambience to another. These include other operations associated with the development, manufacture, inspection and testing of microelectronic devices such as: lithography, etching, ion implant, epitaxy, electron microscopy, chemical vapor deposition, vacuum deposition, and various combinations of these and other processes and procedures. The invention is also applicable to operations involving the development, manufacture, inspection and testing of superconductor devices, solar cells, magnetic data disks, magneto-optical data disks, optical data disks, CD ROM disks, video disks, compact audio disks, and video still camera and recorder disks. Operation of the wafer transfer system may be automated by using computer control with appropriate software. Consequently, a very simple design has been implemented with a low number of mechanical parts and mechanical action. Therefore, low manufacturing costs with high reliability are achieved.

The presently claimed invention provides a high speed vacuum lock chamber for transferring large diameter semiconductor wafers. Such vacuum lock chamber provides a minimum contamination by gas for SEM wafer inspection applications.

Some embodiments of a wafer transfer system in accordance with the invention will be described by way of example with reference to the accompanying drawings in which:

Figure 1 is a cross section of a wafer transfer system according to the invention; and

Figure 2 is a top view of a portion of a wafer transfer system according to the invention.

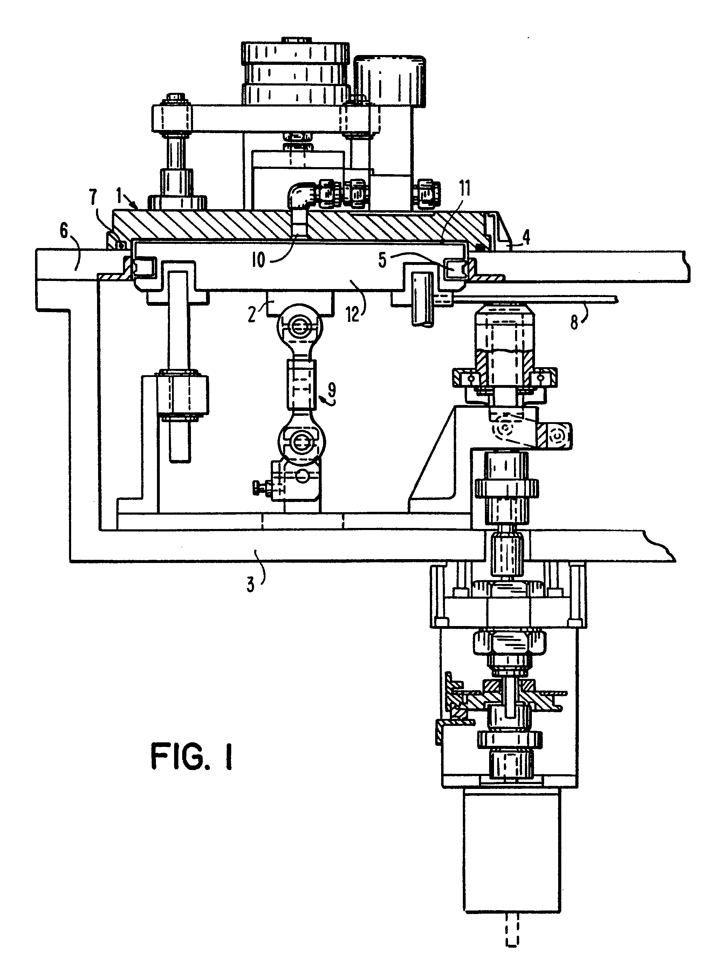

Figure 1 illustrates a mechanism according to the present invention for achieving high speed wafer transfer into an inspection system, such as a SEM as described in Applicants' corresponding application (2704-0020) filed on even date herewith. The wafer transfer system includes a door 1 for loading wafers into a vacuum chamber 3 and locking the vacuum chamber from the environment, and an elevator 2, which are both mounted onto and into the vacuum chamber 3. The door 1 is preferably circular and isolates the lock chamber 11 from the atmosphere, and the wafer elevator 2 also isolates the door from the main vacuum chamber by way of an inflatable sealing means 5 when the door is opened. The door contains a circular O-ring seal 7 and associated air valves 10 for lock pre-evacuation venting.

Wafer access occurs when the door 1 is open. A circular sealing structure 4, for example a ring shield, encloses the majority of the door circumference so that when the door is open, the structure is partly isolated from the atmospheric environment.

The elevator unit 2 contains the circular inflatable vacuum sealing means 5 around its periphery. When pressurized, the sealing means 5 seals the lock chamber onto the round opening of the lid 6 of the vacuum chamber 3 when the elevator 2 is in the position shown in Figure 1.

The elevator has the further function of transferring a wafer into the vacuum chamber 3. A rotary transfer arm 8 is located inside the vacuum chamber 3 and is used to tranfer the wafer from an elevators stage 12 to an internal stage chuck (not shown) for the inspection apparatus

A drive linkage 9, also known as a toroidal latch, is provided for moving the elevator 2 up and down. This movement is a sinusoidal motion where the movement at start and stop of the elevator 2 is slow, while the motion in the middle of movement of the linkage is fast. No abrupt motion occurs in order to eliminate sliding or vibration of the wafer on the elevator 2.

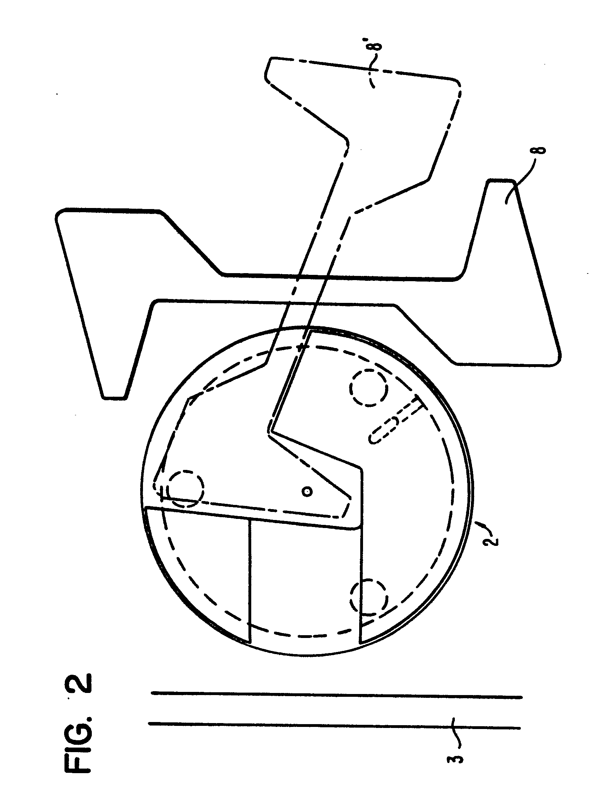

The elevator structure and the transfer arm 8 may be further seen by way of Figure 2 in which the stage 12 is shown as a circular arrangement seen from the top onto which the wafers are provided. The transfer arm 8 is rotatable over the stage 12 of the elevator, after it is lowered, to pick up wafers and move them off of the stage. In a wafer queueing mode of operation in which incoming and outgoing wafer are transferred, the internal transfer arm will swap the wafers. A robotic arm (not shown) transfers the wafers between cassettes of wafers, an optical pre-aligner, and the elevator structure 2.

In operation, for introducing wafers, the door 1 is raised to the extent of the lip of the circular ring shield 4. The wafer is inserted onto the elevator, and the door is brought downward into sealing relationship to the Lid 6 of the vacuum chamber. At that point, the elevator 2 is lowered to a position so that the transfer arm 8 will take the wafer from the elevator's stage 12 and transfer it internally into the internal structure of the vacuum chamber.

Alternate operations can occur in the structure of the present invention. First, before the sealing means 5 is deflated, a rough evaouation is caried out under the door 1 to evacuate a majority of the gas. Then the door 1 is closed, and the sealing means 5 is deflated. Thereafter the elevator 2 is lowered. This minimizes the amount of gas transferred to the vacuum chamber 3.

In a second arrangement, no such rough evacuation is carried out and the subsequent evacuation of the vacuum chamber is necessary to create a proper vacuum.

With a structure as described, an operation sequence can be obtained for a single wafer operation in which the throughput is at least approximately 40-50 wafers per hour. In addition, a "pipeline" mode of operation has been established in which multiple wafers can be input into the vaccum system for measurements and subsequently output from the system. The system throughput under such multiple wafer conditions are at least approximately in the range of 60 to 70 wafers per hour.

## Claims

1. A wafer transfer system for transferring a wafer from a space at a predetermined pressure into a vacuum chamber through an opening in the vacuum chamber, characterized in that the transfer system comprises door means for removably covering the opening, elevator means located at least partly inside the vacuum chamber comprising a stage for moving wafers from the opening into the vacuum chamber, and sealing means for forming a vacuum seal between sides of the stage and walls bounding the opening.

2. A wafer transfer system as claimed in Claim 1, characterized in that a lock chamber is enclosed by the door means and the stage, opposite sides of the lock chamber having approximately equal shape and surface area as the wafers.

3. A wafer transfer system as claimed in Claim 2, characterized in that a hight of the lock chamber is approximately equal to the hight of at least one wafer.

4. A wafer transfer system as claimed in Claim 1, 2 or 3, characterized in that transfer means are located at least partly within the vacuum chamber, for positioning the wafers within the vacuum chamber.

5. A wafer transfer system as claimed in Claim 4, characterized in that the transfer means comprise a rotary arm, located inside the vacuum chamber.

6. A wafer transfer system as claimed in any one of the preceding claims, characterized in that the door means is movable in the same direction as the elevator means, part of the circumference of the door means being enclosed by a sealing structure, that is connected to an outer part of the vacuum chamber.

7. A wafer transfer sytem as claimed in any one of the preceding Claims, characterized in that a further seal is provided between the door means and an outer part of the vacuum chamber, the sealing means and the further seal being of circular shape.

FIG. I

FIG. 2

EP 0 384 524 A2